# EUROPEAN PATENT APPLICATION

(11) **EP 4 382 926 A1**
(43) Date of publication of application: **12.06.2024**
(21) Application number: 22211683.2
(22) Date of filing: 06.12.2022
(51) Int. Cl.: G01R 31/28, G01R 31/319

(54) **INTERFACE ELEMENT WITH ELASTIC PROPERTIES PROVIDED WITH INTERNAL ELECTRIC VIAS, IN PARTICULAR FOR CONNECTING A DEVICE TO BE TESTED TO A TESTING HEAD, AND METHOD FOR MANUFACTURING SAID INTERFACE ELEMENT**

(71) Applicant: Microtest S.p.A., 56010 Vicopisano (IT)
(72) Inventor: AMELIO, Giuseppe, 55100 San Pietro (LU) (IT)
(74) Representative: Botti & Ferrari S.p.A.

(57) **Abstract**

The present disclosure relates to an interface element (1; 1') arranged to put a plurality of terminations of a device to be tested in contact with corresponding channels of a testing head, comprising at least one elastomeric matrix (2) and a plurality of conductors (3; 3') embedded in said elastomeric matrix (2); said interface element (1; 1') having an upper face (4) and a lower face (5) which are substantially parallel and spaced apart by a thickness (T) measured along a vertical direction (X); said conductors (3; 3') being separated from each other and passing through the whole thickness (T) of the interface element (1; 1') from the upper face (4) to the lower face (5), said conductors (3; 3') having at least one portion which is not parallel to said vertical direction (X).

## Description

### Field of application

The present invention relates to an interface element provided with a main body with elastomeric properties traversed from side to side by a plurality of internal electric vias.

This interface element finds a useful application in a testing head arranged to perform tests on electronic devices, for example integrated electronic circuits.

In particular, the interface element is intended to put a plurality of terminations or pads of the device to be tested in contact with corresponding channels of the testing head to automatically perform some tests on the electronic device, so as to identify and discard defective products.

It should also be noted that the interface element can find a useful application in any electronic equipment where a plurality of electronic terminations must be put in temporary electric contact, in particular in any testing equipment on electronic devices or components thereof.

The invention also relates to a method for manufacturing said interface element.

### Prior art

In the field of the invention, it is known to use testing heads of the above type which usually comprise a pair of guide plates arranged parallel to each other in a prefixed spaced apart relation and equipped with a plurality of guide and housing holes for probes or needles which represent contact elements for the terminations of the integrated circuits.

These contact probes of the testing head are formed by wires of special alloys which have peculiar electrical and mechanical properties, and which pass through the holes of the plates emerging from one of the two plates with an end or contact head.

The probes are mounted and held between the two plates in a position which is substantially perpendicular to the plates themselves so that, in the jargon of this specific technical field, they are referred to as "vertical probes". This specific substantially vertical configuration allows a relatively high number of probes per unit area to be incorporated, so as to be able to perform tests even on integral circuits characterized by extremely reduced pitches, in the order of 30-40 pm for the latest generation integrated circuits.

More particularly, the holes of the respective plates through which a given probe passes are in general slightly offset so that each probe is axially movable through the respective housing holes but with some friction which, along with the inherent flexibility of the probes themselves, confers a certain overall ability to withstand compression to the entire testing head, as if it were slightly cushioned.

Although substantially meeting the field requirements, the above-outlined device has nevertheless some drawbacks, related to the production cost, to the relative fragility of the probes which can get damaged requiring a complex replacement work, and finally to the difficulties in forming extremely reduced pitches which are inherent in prior art technology.

The technical problem underlying the present invention is to conceive a new interface element which solves, or at least mitigates, the above-lamented drawbacks, and which allows in particular an effective cushioning without resorting to mechanical elements - such as needle probes - which are difficult to assemble and replace.

### Summary of the invention

The solution idea underlying the present invention is to provide a bearing of elastomeric material in which some metal conductors performing the probe function are embedded, wherein the bearing elasticity required to cushion the contacts is ensured by a non-vertical conformation of the above conductors.

Based on the above solution idea, the technical problem is solved by an interface element arranged to put a plurality of terminations of a device to be tested in contact with corresponding channels of a testing head, comprising at least one elastomeric matrix and a plurality of conductors embedded in said elastomeric matrix; said interface element having an upper face and a lower face which are substantially parallel and spaced apart by a thickness measured along a vertical direction; said conductors being separated from each other and passing through the whole thickness of the interface element from the upper face to the lower face, said conductors having at least one portion which is not parallel to said vertical direction.

It should be noted that the term "vertical" refers to a prevalent use of the probe, but it should not be understood in a limited sense. In the context of the present application, a direction which is substantially orthogonal to the prevalent planar development of the interface element is to be understood as vertical.

A person skilled in the art will appreciate how the above interface element allows the system of needle probes described in the section dedicated to the prior art to be advantageously replaced, and how it can further find a useful application in any other equipment intended to perform tests on electronic equipment or parts thereof.

In fact, it should be noted that the above conductors have lower contact points and upper contact points emerging from the lower face and from the upper face respectively, and arranged to contact the above terminations and/or the above channels.

The distance between the different contact points is preferably fixed, and the distance between two adjacent contact points is preferably less than 50 pm, more preferably comprised between 20 and 40 pm.

Advantageously, one of the faces of the device, for example the lower face, can be integrally associated with an electronic substrate with which the electrical connection must be performed. This substrate can be a printed board, a wafer, or other device or device part.

In a first embodiment of the present invention, each of said conductors comprises a plurality of conductive segments oriented in a different direction and overlapped in the vertical direction.

Thanks to this expedient, it is possible to form a spring structure wherein the segment alternation confers elasticity to the entire conductor and, accordingly, to the interface element.

Preferably, the conductive segments are, in this case, vertical conductive segments, oriented along the vertical direction, alternated with horizontal segments, oriented along a direction which is horizontal to the faces of the interface element.

A bending of the successive vertical segments can be thereby obtained, while keeping the substantial linearity of the entire conductor, thus forming the above-discussed spring structure.

Preferably, said horizontal segments are vertically overlapped, while said vertical segments are vertically overlapped two by two.

This conformation keeps the axial dimensions of the conductors limited.

In the here-outlined spring structure, the different conductors have an identical structure with respect to each other, the vertical segments of the different conductors being parallel and equally spaced from each other, the horizontal segments of the conductors lying on a same intermediate plane of the interface element.

In a second embodiment of the present invention, said conductors are inclined by an inclination angle with respect to said vertical direction.

Once more an elastic configuration of the conductors is thereby obtained, which allows the interface element to be compressed since the conductors themselves can deform further inclining with respect to the vertical.

In the above configuration, the different conductors are preferably parallel to each other.

Preferably, said inclination angle is comprised between 15° and 45°, so as to sufficiently depart from the vertical but to allow a great margin of further rotation towards the horizontal.

The above-identified technical problem is also solved by a method for manufacturing an interface element arranged to put a plurality of terminations of a device to be tested in contact with corresponding channels of a testing head, comprising the steps of:
a) arranging at least one elastomer layer, which rises vertically from a lower face to an upper face;
b) forming a plurality of vias which are distinct from each other passing through the elastomer layer from the lower face up to the upper face;
c) filling said vias with a conductive material to form as many conductive segments;
wherein, at the end of the manufacturing method, the layers define an elastomeric matrix extended between an upper face and a lower face which are substantially parallel and spaced apart by a thickness measured along a vertical direction and the conductive segments define conductors provided with at least one portion which is not parallel to the vertical direction.

In a preferred embodiment, at least one first elastomer layer is deposited and cured directly on a substrate, which can be a PCB, a wafer or the like.

The elastomer being used may be then advantageously a synthetic elastomer of the cross-linkable type, preferably through a curing process.

The step of forming said vias is preferably performed according to a photolithographic process, i.e. it provides a sub-step of imprinting, for example by laser, the elastomer layer and a following sub-step of removing by chemical etching the imprinted material.

To allow the use of the photolithographic process, the elastomeric matrix may be preliminarily made sensitive to radiation, for example by adding a photosensitizing agent like a photosensitive resin.

In a per-se-known manner, in the sub-step of imprinting the elastomer layer imprint masks are used, which must be accurately positioned by means of fiducial markers for obtaining a proper alignment i.e. an overlapping of the vias possibly formed on successive layers.

The chemical etching which follows the imprinting, removing the imprinted elastomer, allows voids to be obtained, which are then to be filled with a preferably metal conductor.

Preferably, the step of filling said vias uses the galvanic deposition of a metal conductor.

In an alternative embodiment, the above steps are repeated to form a plurality of layers, the conductive segments corresponding to successive layers being oriented in different directions and connected to form a broken line.

In fact, it should be noted that, when forming a single layer, the use of the photolithographic process results in the formation of voids which develop in a normal manner with respect to the upper face of the layer itself, i.e. which develop in the vertical projection below the mask being used. The manufacture by successive layers allows therefore vertical orifices, directed in the normal direction to the upper face of the interface element, to be alternated with substantially horizontal connectors therebetween, so as to define a broken profile of the conductor.

In particular, said layers can comprise thicker layers alternated with less thick layers; the vias formed at the thicker layers being vertical vias whose extension in the vertical direction prevails with respect to the extension in the horizontal direction; the vias formed at the less thick layers being horizontal vias whose extension in the horizontal direction prevails with respect to the extension in the vertical direction; the corresponding conductive segments being vertical segments and horizontal segments respectively.

Preferably, the above horizontal vias are vertically overlapped, while the vertical vias are vertically overlapped two by two. Hence, imprint masks having only three different geometries will be required to form all the layers of the interface element.

As an alternative to the above-discussed variant, the method can provide the deposition of a single layer on which vertical vias and vertical conductive segments oriented along the vertical direction are then formed; the method further comprising a step of applying a shearing stress to the layer to incline the vertical conductive segments by an inclination angle with respect to the vertical direction.

The verticality constraint imposed by the formation of the vias through a photolithographic process is thereby avoided without resorting to a plurality of successive depositions.

The features and advantages of the testing head and of the related assembly method will be apparent from the description of two exemplary embodiments given by way of non-limiting example with reference to the attached drawings.

### Brief description of the drawings

Figures 1-24 schematically show the successive steps of a process for manufacturing an interface element according to a first embodiment;
Figure 25 schematically shows the interface element manufactured by following the process of Figures 1-24;
Figures 26-32 schematically show the successive steps of a process for manufacturing an interface element according to a second embodiment;
Figure 33 schematically shows the interface element manufactured by following the process of Figures 26-32.

### Detailed description

With reference to the figures of the attached drawings, an interface element arranged to put a plurality of terminations of a device to be tested in contact with corresponding channels of a testing head is globally and schematically identified with 1, 1'.

It should be first pointed out that the figures are schematic views and are not drawn to scale but so as to emphasize the most important aspects and features of the present disclosure. The shapes of the elements and of the parts composing the interface element are not to be understood in a binding sense as well.

The interface element 1, 1' is illustrated in the figures in an embodiment configuration. The relative and absolute positions and orientations of the various parts composing the element, defined by terms like upper and lower, above and below, horizontal and vertical or other equivalent terms, are always to be construed with reference to this configuration.

As identified in the paragraph dedicated to the field of application, the interface element 1, 1' is intended to put a plurality of terminations or pads of a device to be tested in contact with corresponding channels of the testing head to automatically perform some tests on the electronic device, so as to identify and discard defective products.

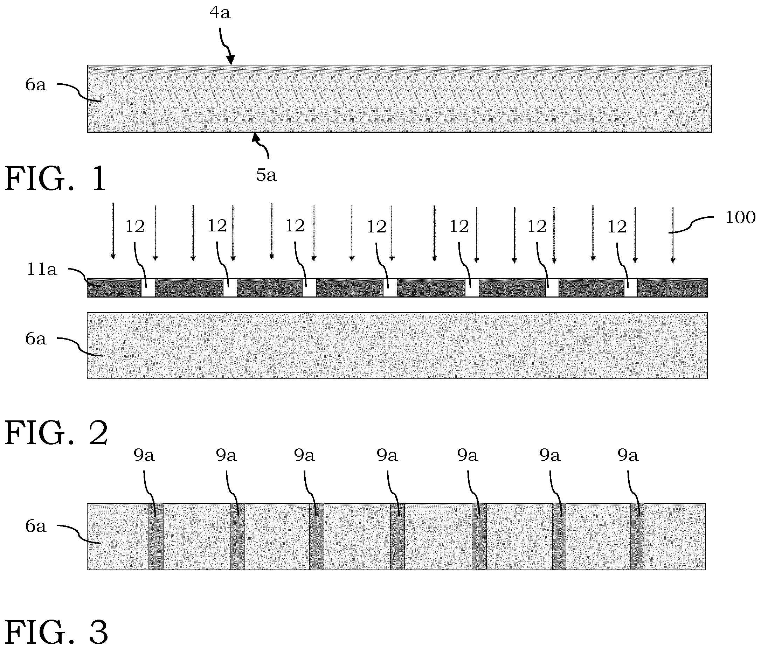

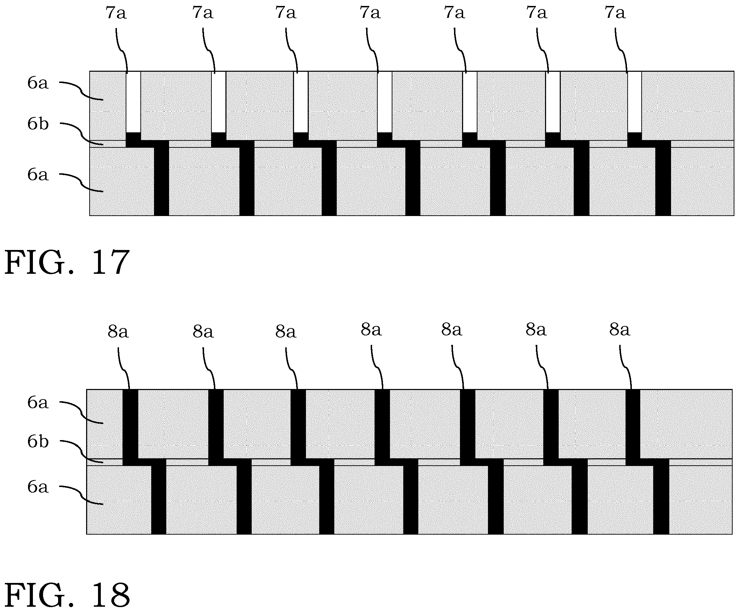

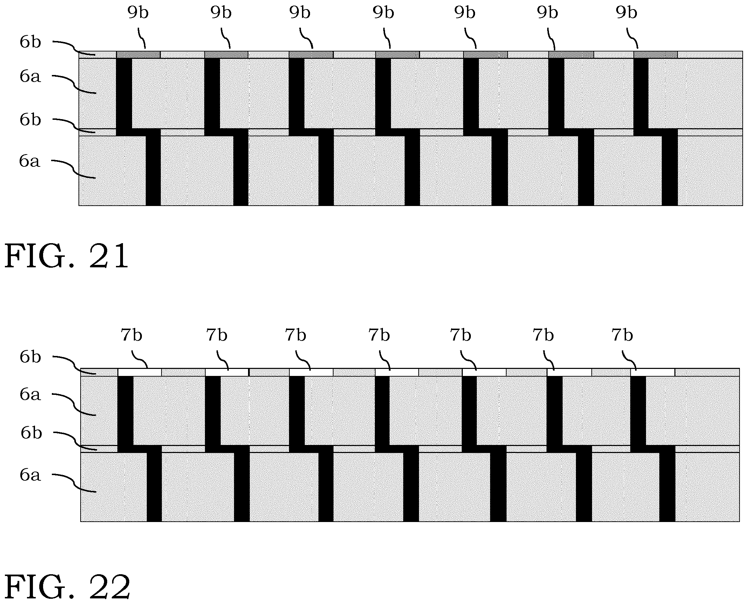

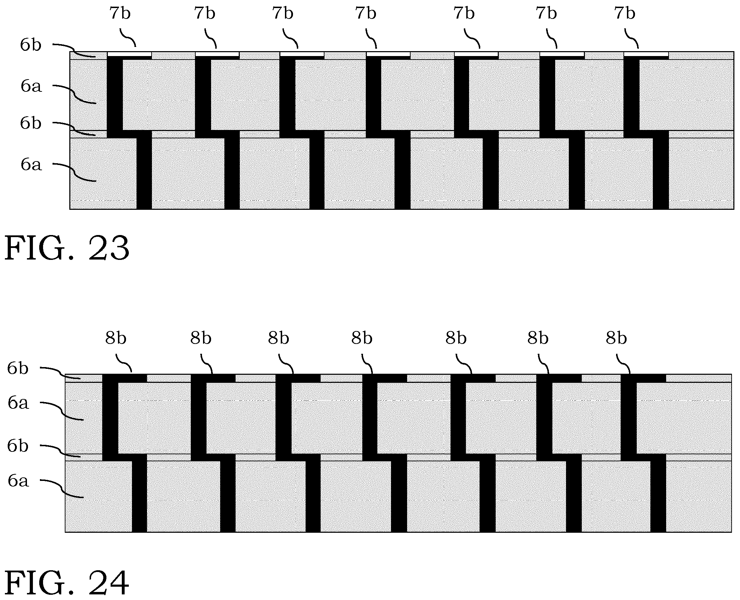

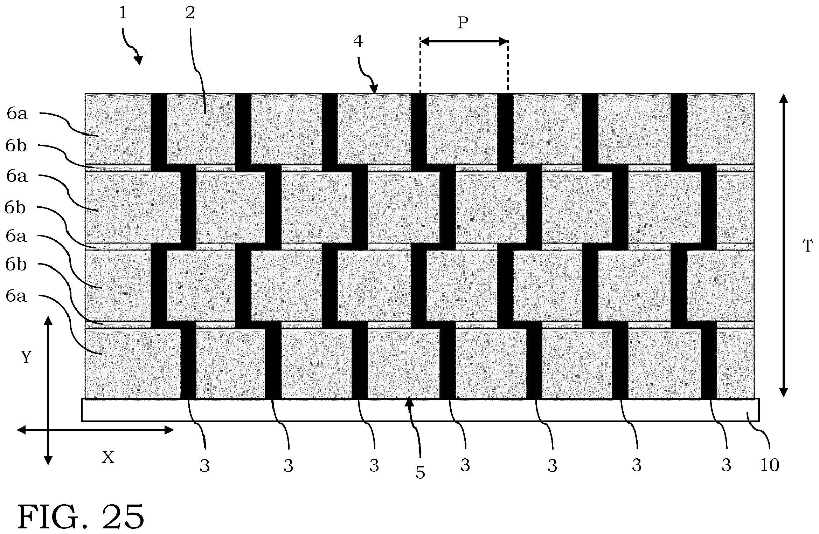

An interface device 1 according to a first variant, which can be individually seen in Figure 25, is obtained through a manufacturing process by successive layers, illustrated in Figures 1-24 and described hereafter.

In a first step, illustrated in Figure 1, a first layer 6a of elastomeric matrix is deposited, particularly arranged for subsequent photolithographic operations. The first layer extends between an upper face 4a and a lower face 5a, which are both horizontal.

Preferably, the first layer 6a is deposited and cured directly on a substrate 10, which can be seen only in Figure 25, which can be a PCB, a wafer or the like.

Once the first layer is cured, a first photolithographic operation is performed to form first vertical vias 7a.

As can be schematically seen in Figure 2, a mask 11a which defines the location of a plurality of vertical vias 7a which are equally distant from each other overlaps with the cured layer 6a. The mask provides for this purpose a plurality of point-shaped orifices 12 spread along the surface thereof: in the sectional figure the sole orifices 12 lying on the sectional plane are represented.

Figure 2 also shows, by means of arrows 100, the application of a radiation, for example a laser one, which imprints the underlying first layer 6a.

The following Figure 3 still illustrates the result of imprinting, i.e. a plurality of imprinted areas 9a on the elastomeric matrix at the orifices 12 of the mask 11a.

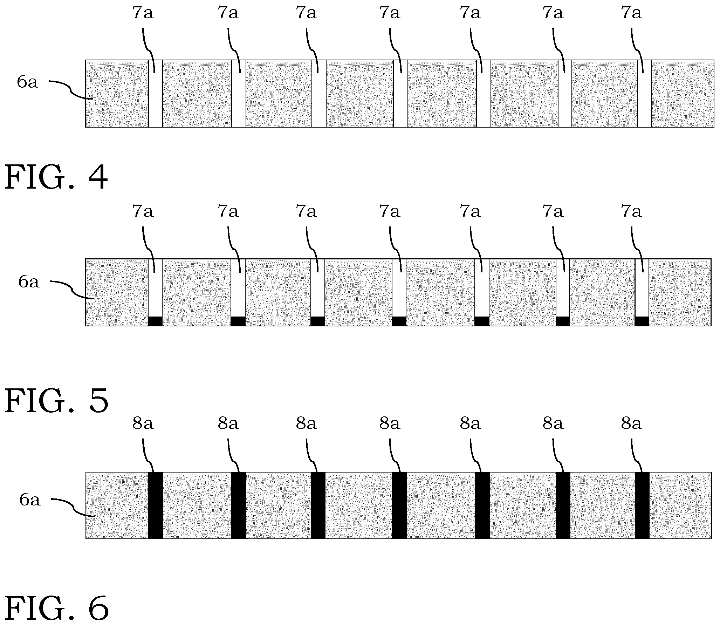

In a following step of the process, the first layer undergoes a chemical etching which promotes the removal of the material in imprinted areas, resulting in a plurality of vertical hollow and through vias 7a which connect the upper face 4a and the lower face 5a, as can be seen in Figure 4.

In a further following step, illustrated in Figure 5, the vertical vias 7a are gradually filled with a metal conductor by galvanic deposition.

This step results in the formation of a plurality of vertical conductive segments 8a, illustrated in Figure 6, which connect the upper face 4a to the lower face 5a.

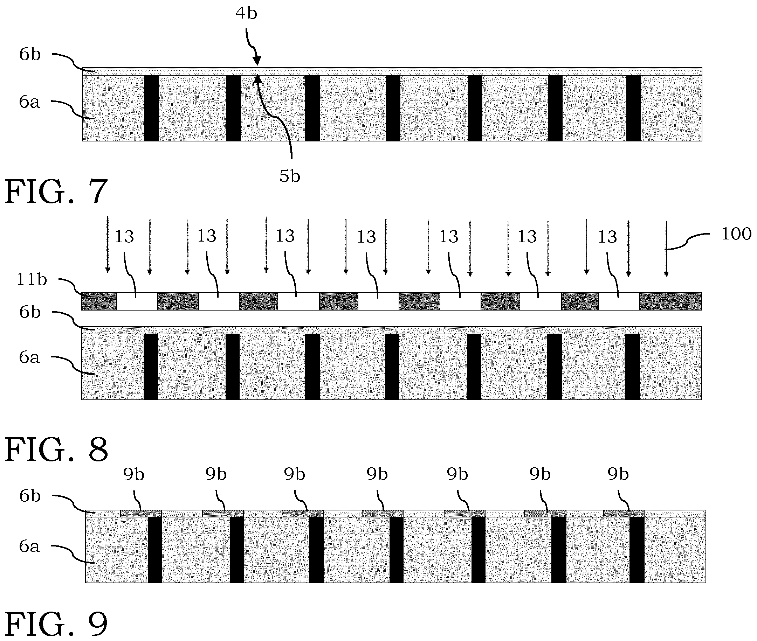

A following step, illustrated in Figure 7, provides the deposition of a successive layer 6b of elastomeric matrix, having a much lower thickness than the first one. This second layer 6b also extends between a lower face 5b, corresponding to the upper face of the first layer 6a, and an upper face 4b which is free at the time of deposition.

The less thick layer 6b has a thickness which is a fraction of the thicker layer 6a, approximately less than a half.

As can be seen in Figure 8, a second mask 1 1b is applied on the second layer 6b, having a different geometry with respect to the above-discussed first mask 11a. In particular, the second mask 11b provides, instead of the point-shaped orifices 12 of the first mask, a corresponding plurality of elongated orifices 13 intended to define preferably rectilinear, horizontally developed segments 8b.

By suitably using fiducial markers, the second mask 11b will be arranged so that the horizontal segments 8b connect at an end thereof with the vertical segments of the first layer 6a.

The exposure to a radiation 100, for example a laser one, thus results in the formation of a plurality of imprinted areas 9b on the less thick layer 6b of the elastomeric matrix as can be seen in Figure 9.

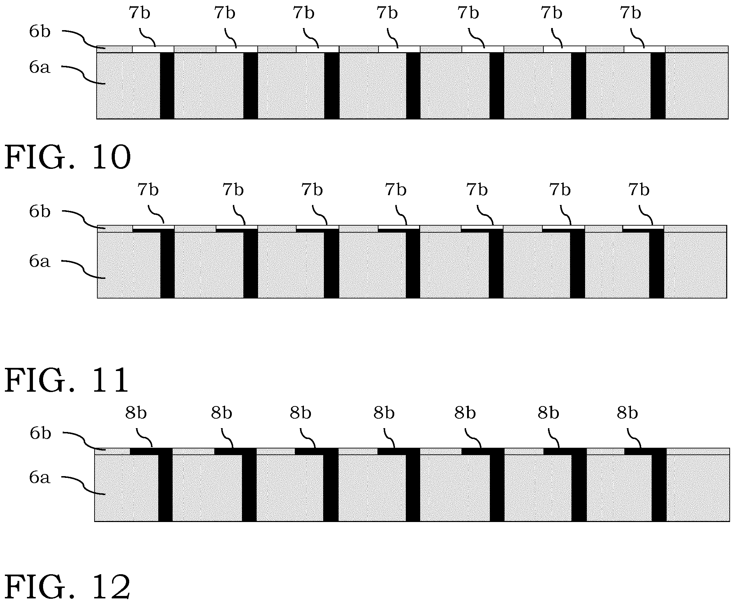

Similarly to what is done for the thicker layer 6a, a chemical etching is thus performed, which serves to free the horizontal vias 7b illustrated in Figure 10.

Figure 11 thus shows the following filling process by galvanic deposition, which finally results in the formation of the horizontal conductive segments 8b which can be seen in Figure 12.

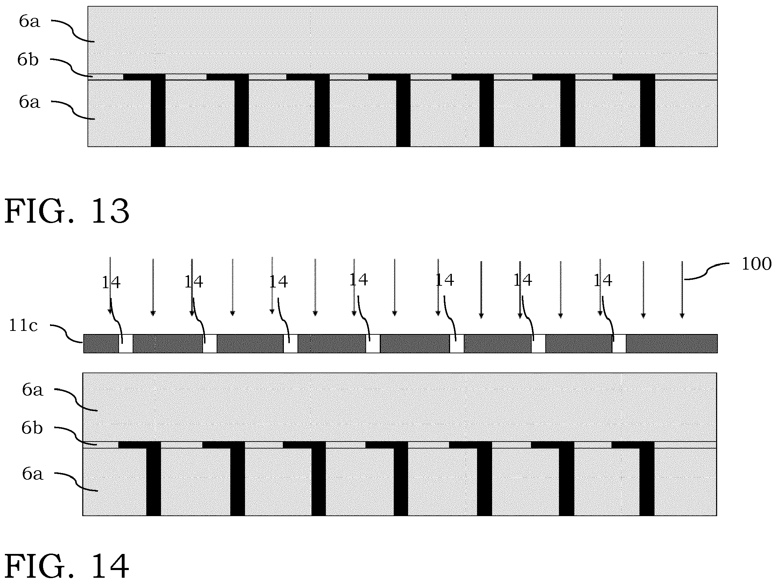

The process thus provides the deposition of a new layer 6a having the same thickness as the first layer 6a, as illustrated in Figure 13.

On this thicker layer 6a a third mask 11c is applied, shown in Figure 14, which is provided with a plurality of point-shaped orifices 14 having the same size as those of the first mask, but which are suitably arranged at the opposite ends of the horizontal segments 8b. Similarly to the foregoing description, the third mask 11c is exposed to a laser radiation 100.

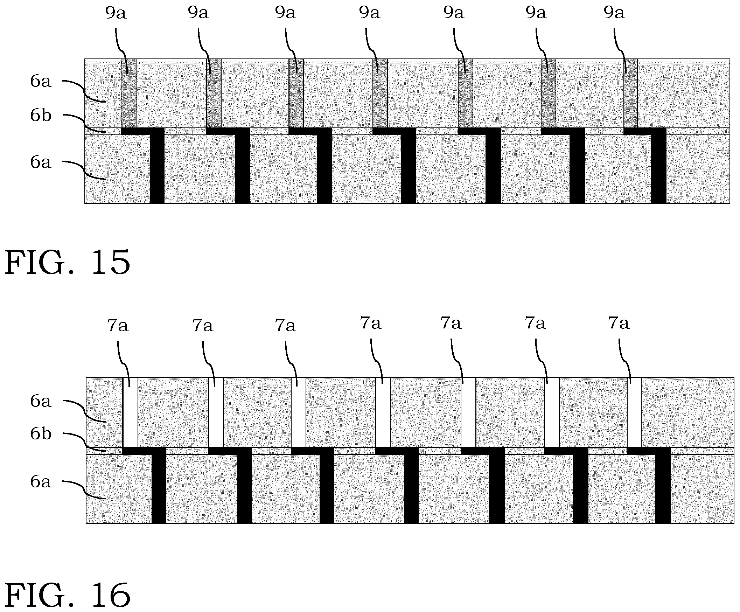

The following Figures 15, 16, 17 and 18 show, similarly to the formation of the previous layers, the fact of obtaining a plurality of imprinted areas 9a, the following removal by chemical etching to define the vertical vias 7a, and the filling by galvanic deposition to obtain vertical conductive segments 8a which connect to the underlying horizontal conductive segments 8b.

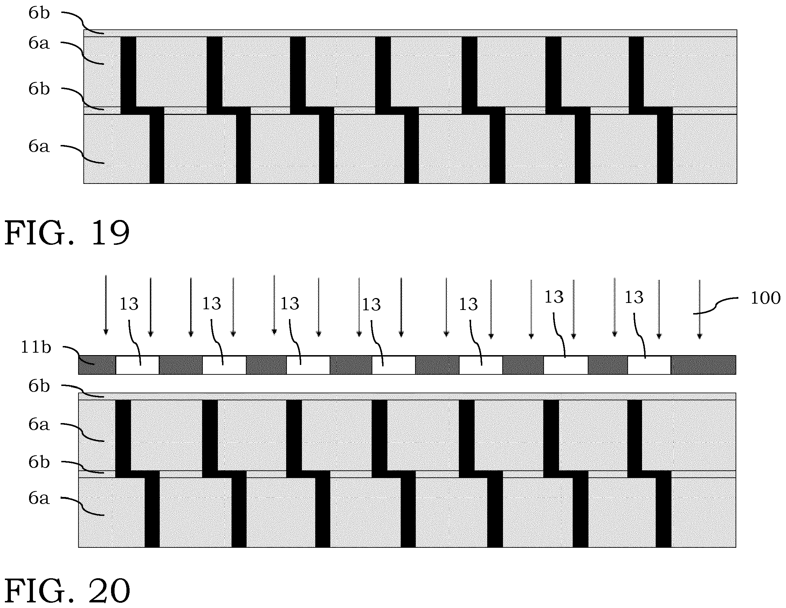

Afterwards, a less thick layer 6b is formed once more, on which, through the use of a second mask 11b, imprinted areas 9b are obtained, i.e. horizontal vias 7b and finally horizontal conductive segments 8b fully overlapped with those of the above-discussed second layer 6b. The last procedural steps are schematically illustrated in Figures 19, 20, 21, 22, 23 and 24.

From this point on, the above-discussed process steps are repeated by alternating thicker layers 6a with less thick layers 6b, wherein the thicker layers 6a have in an alternated manner vertical conductive segments 7a located on the one or on the other end of the horizontal conductive segments 8a.

An interface element 1 as illustrated in Figure 25 is therefore manufactured, which has a plurality of layers overlapped to define an overall thickness T developed along a vertical direction Y. The so-obtained interface element has a plurality of conductors 3 which pass through an elastomeric matrix 2 from an upper face 4 to a lower face 5.

As is apparent from the description of the manufacturing method, the conductors 3 develop according to broken lines and alternate vertical segments 7a, extended along the vertical direction Y, with horizontal segments 7b extended along a horizontal direction X which is substantially normal to the vertical direction Y.

As mentioned in the summary of the invention, the alternation between vertical segments 7a and horizontal segments 7b confers to the conductor a spring conformation which ensures the elasticity required for testing head applications.

The pitch P, i.e. the minimum input distance between a conductor 3 and another adjacent conductor 3, is preferably less than 50 pm, more preferably comprised between 20 and 40 pm.

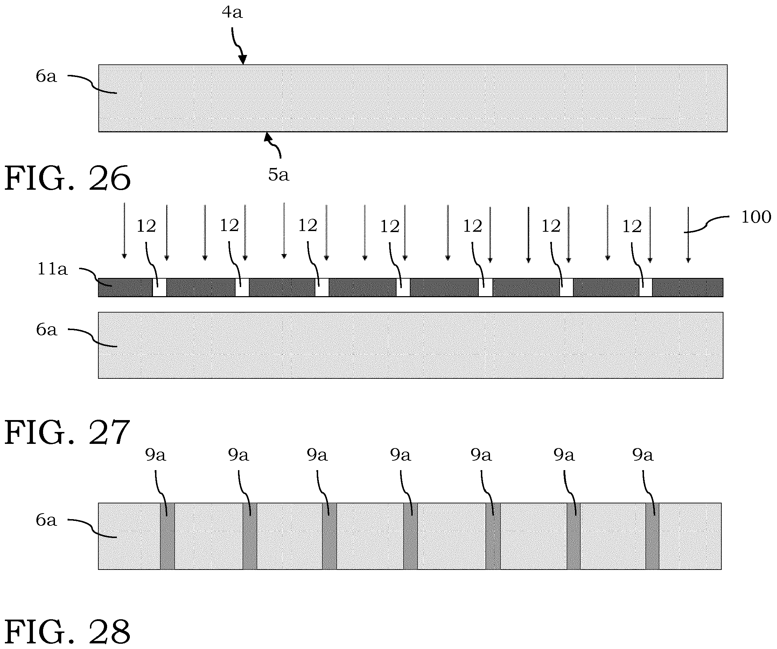

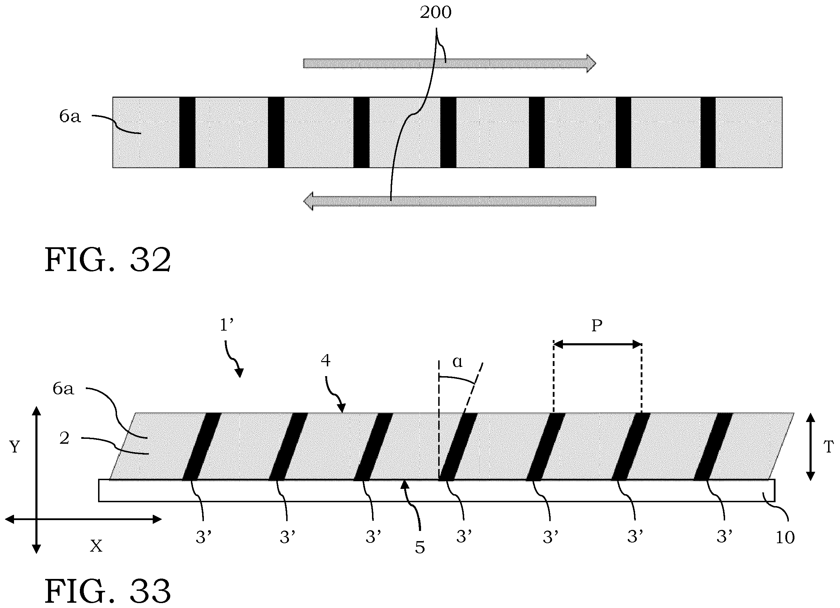

An interface device 1' according to a second variant, which can be individually seen in figure 33, is obtained through a different manufacturing process, illustrated in figures 26-32 and described hereafter.

In a first step, illustrated in Figure 26, a layer 6a of elastomeric matrix is deposited, particularly arranged for subsequent photolithographic operations. The first layer extends between an upper face 4a and a lower face 5a, which are both horizontal.

Preferably, the layer 6a is deposited and cured directly on a substrate 10, which can be seen only in Figure 33, which can be a PCB, a wafer or the like.

Once the layer is cured, a photolithographic operation is performed to form first vertical vias 7a.

As can be schematically seen in Figure 27, a mask 11a which defines the location of a plurality of vertical vias 7a which are equally distant from each other overlaps with the cured layer 6a. The mask provides for this purpose a plurality of orifices 12 spread along the surface thereof: in the sectional figure the sole orifices 12 lying on the sectional plane are represented.

Figure 27 also shows, by means of arrows 100, the application of a radiation, for example a laser one, which imprints the underlying elastomeric layer 6a.

The following Figure 28 still illustrates the result of imprinting, i.e. a plurality of imprinted areas 9a on the elastomeric matrix at the orifices 12 of the mask 11a.

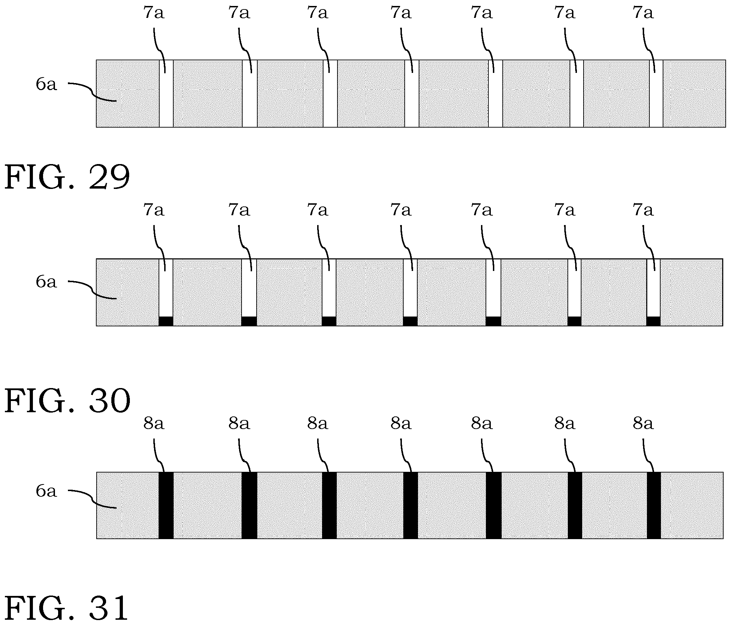

In a following step of the process, the layer undergoes a chemical etching which promotes the removal of the material in the imprinted areas, resulting in a plurality of vertical hollow and through vias 7a which connect the upper face 4a and the lower face 5a, as can be seen in Figure 29.

In a further following step, illustrated in Figure 30, the vertical vias 7a are gradually filled with a metal conductor by galvanic deposition.

This step results in the formation of a plurality of vertical conductive segments 8a, illustrated in Figure 31, which connect the upper face 4a to the lower face 5a.

In this embodiment, further layers after the first one are not formed. On the contrary, a following step of applying a shearing stress 200 is provided, schematically illustrated in Figure 32.

This application of the shearing stress can be performed for example by constraining the elastomeric layer 6a in a stiffener with an inclined structure, or with other equivalent systems.

The application of the shearing stress results in the inclination of the elastomeric layer 6a and of the vertical segments 7a embedded therein. The latter take in particular an inclined configuration with respect to a vertical direction Y conferring to the manufactured article the elasticity required for the applications thereof in the reference technical field.

Hence, the above-described alternative manufacturing method allows an interface element 1' as illustrated in Figure 33 to be obtained, wherein the elastomeric matrix 2 has therein conductors 3' inclined by an angle α, which is preferably equal to 30°, with respect to the vertical direction Y. The conductors 3' connect, in this case too, an upper face 4 to a lower face 5 extending along the whole thickness T of the interface element.

Hence, the solution of the present disclosure solves the technical problem and achieves several advantages including: a particularly reduced cost and a great structural and functional reliability.

In understanding the scope of the present invention, the term "comprising" and derivatives thereof, as used herein, are intended as open terms which specify the presence of the specified features, elements, components, groups, integers and/or steps, but do not exclude the presence of other non-specified features, elements, components, groups, integers and/or steps. The foregoing also applies to words having similar meanings such as for example the terms, "including", "having" and derivatives thereof. Moreover, the terms "part", "section" and "portion" when used in the singular form may have the double meaning of a single part or of a plurality of parts unless otherwise specified.

Although only selected embodiments were chosen to illustrate the present invention, it will be apparent to the persons skilled in the art from this disclosure that various changes and modifications can be brought here without departing from the scope of the invention as defined in the attached claims.

## Claims

1. Interface element (1; 1') arranged to put a plurality of terminations of a device to be tested in contact with corresponding channels of a testing head, comprising at least one elastomeric matrix (2) and a plurality of conductors (3; 3') embedded in said elastomeric matrix (2); said interface element (1; 1') having an upper face (4) and a lower face (5) which are substantially parallel and spaced apart by a thickness (T) measured along a vertical direction (X); said conductors (3; 3') being separated from each other and passing through the whole thickness (T) of the interface element (1; 1') from the upper face (4) to the lower face (5), said conductors (3; 3') having at least one portion which is not parallel to said vertical direction (X).

2. Interface element (1; 1') according to claim 1, wherein one of the faces (4, 5) is integrally associated with a substrate (10).

3. Interface element (1) according to one of the preceding claims, wherein each of said conductors (3) comprises a plurality of conductive segments (8a; 8b) oriented in a different direction and overlapped in the vertical direction (X).

4. Interface element (1) according to claim 3, wherein said conductive segments (8a; 8b) are vertical conductive segments (8a), oriented along the vertical direction (X), alternated with horizontal segments (8b), oriented along a horizontal direction (Y) which is parallel to said upper (4) and lower (5) faces.

5. Interface element (1) according to claim 4, wherein said horizontal segments (8b) are vertically overlapped, said vertical segments (8a) are vertically overlapped two by two.

6. Interface element (1') according to claim 5, wherein said conductors (3') are inclined by an inclination angle (α) with respect to said vertical direction (X).

7. Interface element (1') according to claim 6, wherein said inclination angle (α) is comprised between 15° and 45°.

8. Method for manufacturing an interface element (1; 1') arranged to put a plurality of terminations of a device to be tested in contact with corresponding channels of a testing head, comprising the steps of:
a) arranging at least one elastomer layer (6a; 6b), which rises vertically from a lower face (5a; 5b) to an upper face (4a; 4b);
b) forming a plurality of vias (7a; 7b) which are distinct from each other passing through the elastomer layer (6a; 6b) from the lower face (5a; 5b) up to the upper face (4a; 4b);
c) filling said vias (7a; 7b) with a conductive material to form just as many conductive segments (8a; 8b);
wherein, at the end of the manufacturing method, the layers (6a; 6b) define an elastomeric matrix (2) extended between an upper face (4) and a lower face (5) which are substantially parallel and spaced apart by a thickness (T) measured along a vertical direction (X) and the conductive segments (8a; 8b) define conductors (3; 3') provided with at least one portion which is not parallel to the vertical direction (X).

9. Method for manufacturing an interface element (1; 1') according to claim 8, wherein a first elastomer layer (6a) is deposited and cured directly on a substrate (10).

10. Method for manufacturing an interface element (1; 1') according to one of claims 8 or 9, wherein the step of forming said vias (7a; 7b) is performed according to a photolithographic process and provides a sub-step of imprinting by radiation the elastomer layer (6a; 6b) and a following sub-step of removing the imprinted material.

11. Method for manufacturing an interface element (1; 1') according to one of claims 8-10, wherein said step of filling said vias (7a; 7b) uses the galvanic deposition of a metal conductor.

12. Method for manufacturing an interface element (1) according to one of claims 8-11, wherein the above steps (a, b, c) are repeated to form a plurality of layers (6a; 6b), the conductive segments (8a; 8b) corresponding to successive layers being oriented in different directions and connected to form a broken line.

13. Method for manufacturing an interface element (1) according to claim 12, wherein said layers (6a; 6b) comprise thicker layers (6a) alternated with less thick layers (6b); the vias formed at the thicker layers (6a) being vertical vias (7a) whose extension in the vertical direction (X) prevails with respect to the extension in the horizontal direction (Y); the vias formed at the less thick layers (6b) being horizontal vias (7b) whose extension in the horizontal direction (Y) prevails with respect to the extension in the vertical direction (X); the corresponding conductive segments (8a; 8b) being vertical segments (8a) and horizontal segments (8b) respectively.

14. Method for manufacturing an interface element (1) according to claim 13, wherein said horizontal vias (7b) are vertically overlapped, said vertical vias (7a) are vertically overlapped two by two.

15. Method for manufacturing an interface element (1') according to one of claims 7-10, wherein the method provides the deposition of a single layer (6a) on which vertical vias (7a) and vertical conductive segments (8a) oriented along the vertical direction (X) are then formed; the method further comprising a step of applying a shearing stress to the layer (6a) to incline the vertical conductive segments (8a) by an inclination angle (α) with respect to the vertical direction (X).
